# EUROPEAN PATENT APPLICATION

(11) **EP 0 609 512 A1**
(43) Date of publication of application: **10.08.1994**
(21) Application number: 93119290.0
(22) Date of filing: 30.11.1993
(51) Int. Cl.: C23C 16/44, H01L 21/00

(54) **Apparatus for forming a film**

(30) Priority: 30.11.1992 JP 320505/92
(71) Applicant: CANON SALES CO., INC., Minato-ku, Tokyo 108 (JP); ALCAN-TECH CO., INC., Tokyo 108 (JP); SEMICONDUCTOR PROCESS LABORATORY CO., LTD., Minato-ku, Tokyo 108 (JP)
(72) Inventor: Maeda, Kazuo, c/o Semiconductor Process Lab.Co.Ltd, Tokyo (JP); Ohira,Kouichi, c/oSemiconductor Process Lab.Co.Ltd, Tokyo (JP); Chino,Hiroshi, c/oSemiconductor Process Lab.Co.Ltd, Tokyo (JP); Knowles, James, Moss Beach, Ca 94038 (US); McNaughton, Allen, Newwark, Ca 94560 (US)
(74) Representative: Marx, Lothar, Dr.

(57) **Abstract**

An apparatus for forming a film to form a film on a wafer by the CVD method, which is capable of uniformly keeping the temperature of a gas pipe at a predetermined value with a simple means and without a lot of labor. The apparatus for forming a film of the present invention comprises a reaction gas feeder for evaporating a source by heating it to supply a reaction gas, a wafer holder (21) for mounting a wafer (24) on which a film is to be formed, a gas distributor (30) provided separately from the reaction gas feeder to discharge a reaction gas to a wafer (24), a gas pipe (2a) and (2i) connecting the reaction gas feeder with the gas distributor (30) and sending the reaction gas from the reaction gas feeder to the gas distributor (30), and a heat pipe (1) covering the gas pipe (2a) and (2i).

## Description

### BACKGROUND OF THE INVENTION

### 1. Field of the Invention

The present invention relates to an apparatus for forming a film, particularly to an apparatus for forming a film by the CVD method.

### 2. Description of the Related Art

An existing apparatus for forming a film on a wafer by the CVD method mainly comprises a chamber in which a wafer holder and gas distributor are placed and a film is formed, a reaction gas feeder for producing a reaction gas, and a gas pipe for sending the reaction gas from the reaction gas feeder to the gas distributor.

Recently, the reaction gas frequently uses a gas containing organometallics. For example, TEOS is used as a silicon source and TMPO/TMOP or TMB/TEB is used as an impurity source, and one or more sources of these gases are simultaneously used according to necessity. A source gas is obtained by heating these liquid sources and bubbling them with nitrogen gas or the like and a mixed gas obtained by adding ozone gas to the source gas is used as the reaction gas.

When forming a film on a wafer by using the CVD apparatus, the above reaction gas flows through the gas pipe. In this case, wken the gas pipe is kept at the ordinary temperature, the heated reaction gas has a saturated vapor pressure or higher in the gas pipe, whereby it is liquefied and sticks to the inner wall of the gas pipe. Thus, a problem occurs that the gas pipe is clogged or the reaction gas with a predetermined pressure and composition is not supplied to the gas distributor.

To avoid the above trouble, a ribbon heater is wound on the outer wall of the gas pipe to heat the gas pipe so that the temperature of the gas pipe gets higher than the source heating temperature.

However, because a joint of a plurality of gas pipes has a complex shape, a problem occurs that the ribbon heater cannot uniformly be wound on the joint and the temperature cannot uniformly be kept. Moreover, a problem occurs that a power supply for supplying power to the ribbon heater is required and the size of the apparatus increases.

Furthermore, a problem occurs that a lot of labor is required because the ribbon heater should frequently be renewed because it has a high temperature and thereby it is easily oxidized.

### SUMMARY OF THE INVENTION

The present invention is made to solve the existing problems and its object is to provide an apparatus for forming a film capable of uniformly keeping the temperature of a gas pipe at a predetermined value with simple means and without a lot of labor.

For the apparatus for forming a film of the present invention, the outside of a gas pipe for sending a reaction gas from a reaction gas feeder to a gas distributor at a film forming section is covered with a heat pipe. Therefore, it is possible to uniformly keep the temperature of the gas pipe at a predetermined value with a simple means and without a lot of labor because the outside of the gas pipe can closely be covered even if it is difficult to wind a ribbon heater on the gas pipe due to a complex shape of the gas pipe.

Thus, it is possible to prevent the reaction gas from being liquefied due to decrease of the gas pipe temperature, reaction products from sticking to the inner wall of the gas pipe, and the pressure and composition of the reaction gas from fluctuating.

Moreover, when applying the gas pipe keeped in a required temperature by the heat pipe to an automated continuous apparatus for forming a film, the following functions and advantages are obtained in addition to the above functions and advantages.

Firstly, a wafer holder is separated from a gas distributor and heating means, and rotates around a rotary shaft on the moving surface put between the gas distributor and heating means while holding one or more wafers. Therefore, it is possible to move the wafer on a circular orbit and thereby continuously form films and keep a high throughput.

Secondly, because the wafer holder is separated from the heating means, it is possible to easily connect electric wires to the heating means and thereby simplify the structure and maintenance of the apparatus when the heating means is fixed.

Thirdly, because the wafer holder moves in the state of holding a wafer though it separates from the heating means during movement, it is possible to prevent the temperature of the wafer during movement from decreasing by properly increasing the heat capacity of the wafer holder or wafer mounting table. Thereby, it is possible to form a film with a uniform thickness and an advanced quality on a wafer because the wafer temperature is kept approximately constant.

Fourthly, it is possible to accurately control the production of each wafer and form different types of multilayer films by using a wafer holder on which a plurality of wafer mounting tables are set separately from each other and a gas distributor on which a plurality of gas dischargers are set separately from each other.

### BRIEF DESCRIPTION OF THE DRAWING

Fig. 1 is a side view showing the constitution of a reaction gas feeder of the CVD apparatus of an embodiment of the present invention;
Fig. 2 is a side view showing the constitutions of a gas distributor, wafer holder, and heater of the CVD apparatus of the embodiment of the present invention;
Fig. 3 is a top view showing the detailed constitution of a wafer holder of the CVD apparatus of the embodiment of the present invention;
Fig. 4 is a top view showing the detailed constitution of a gas distributor of the CVD apparatus of the embodiment of the present invention; and
Fig. 5 A to Fig. 5 C are typical top views showing a semiconductor device fabrication method using the CVD apparatus of the embodiment of the present invention.

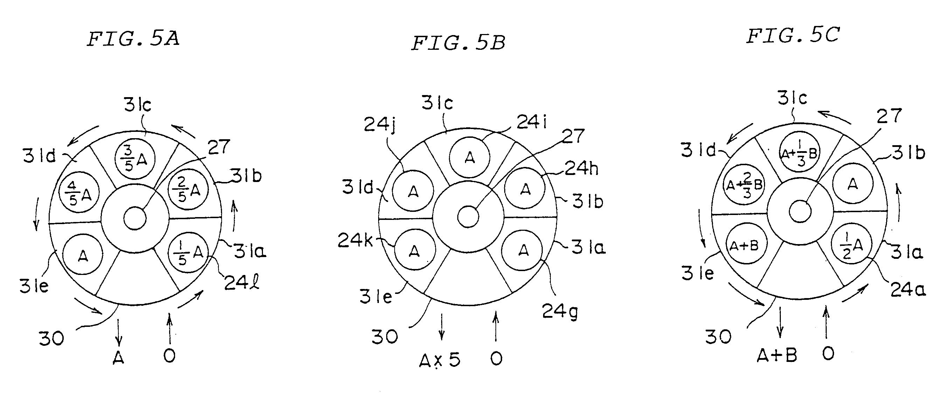

Fig. 5 A is a top view showing a case in which one type of film is formed on a wafer while a wafer holder makes a round of a rotary shaft, Fig. 5 B is a top view showing a case in which wafers are mounted on susceptors one each to simultaneously form a film on all wafers by using one type of reaction gas, and Fig. 5 C is a top view showing a case in which a multilayer film comprising two types of films on one wafer by using two types of reaction gases.

### DESCRIPTION OF THE PREFERRED EMBODIMENT

### (A) Constitution of CVD apparatus of embodiment of present invention

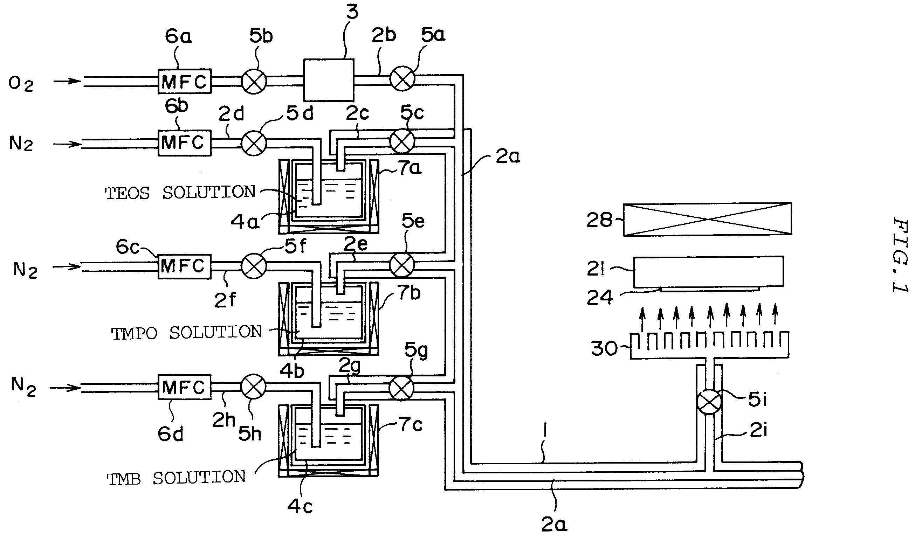

The constitution of the CVD apparatus of an embodiment of the present invention is described below by referring to Fig. 1 to Fig. 4.

### (1) Constitution of reaction gas feeder of CVD apparatus of embodiment of present invention

Fig. 1 is a block diagram of a reaction gas feeder of the CVD apparatus of an embodiment of the present invention.

In Fig. 1, symbol 2a is a gas pipe for sending a reaction gas to a gas distributor 30. A gas pipe 2a is connected to gas pipes 2b, 2c, 2e, and 2g for flowing O₃ (ozone) and nitrogen gas (hereinafter reffered to as N₂ gas) containing TEOS (Tetraethylorthosilicate) or the like and is connected to gas pipe 2i connecting with the gas distributor 30.

Symbol 2b is a gas pipe for flowing oxygen gas (hereinafter reffered to as O₂ gas) and O₃ generated by an ozone generator 3, 2c is a gas pipe for flowing N₂ gas containing TEOS, 2e is a gas pipe for flowing N₂ gas containing TMPO (Trimethylphosphate), and 2g is a gas pipe for flowing N₂ gas containing TMB (Trimethylborate). The gas pipes 2b, 2c, 2e, and 2g are provided with valves 5a to 5c, 5e, and 5g for controlling circulation and stop of gas respectively.

Symbols 2d, 2f, and 2h are gas pipes for sending N₂ gas to vessels 7a to 7c in which TEOS solution, TMPO solution and TMB solution are stored respectively. The pipes are set in the TEOS solution, TMPO solution, and TMB solution to produce N₂ gas (reaction gas) containing TEOS, TMPO, or TMB respectively through bubbling. Moreover, gas pipes 2d, 2f, and 2h are provided with valves 5d, 5f, and 5h for controlling circulation and stop of gas respectively. Furthermore, symbol 2i is a gas pipe branching off from the the gas pipe 2a and connecting with the gas distributor 30, which is provided with a valve 5i for controlling circulation and stop of gas.

Furthermore, symbol 1 is a heat pipe for covering the gas pipes 2a and 2i through which a heated reaction gas circulates and gas pipes 2c, 2e, and 2g through which each source gas circulates. The heat pipe 1 comprises a heat inputting/evaporating section, a heat insulating section, and a heat radiating/condensing section. Portions covering the gas pipes 2a, 2c, 2e, 2g, and 2i correspond to the heat radiating/condensing section but the heat inputting/evaporating section and heat insulating section are not illustrated.

The pressure in a hollow between the inner wall of the heat pipe 1 and the outer walls of the gas pipes 2a, 2c, 2e, 2g, and 2i is reduced and a gaseous working liquid such as flon evaporated in the heat inputting section circulates in the hollow at a speed close to the sonic velocity.

The heat inputting/evaporating section is heated by a not-illustrated heater or hot water because it is necessary to evaporate the working liquid at a temperature equal to the heating temperature of an object to be heated. The working liquid evaporated in the evaporating section passes through the heat insulating section and reaches the heat radiating section to give heat to the gas pipes 2a, 2c, 2e, 2g, and 2i which are objects to be heated.

The working liquid is liquefied again by giving heat to them and the liquefied working liquid returns to the heat inputting/evaporating section through a thin pipe provided on the inner wall of the heat pipe 1. Then, the working liquid is heated and evaporated again in the heat inputting/evaporating section and circulates through the heat pipe 1.

Thereby, the gas pipes 2a, 2c, 2e, 2g, and 2i are heated up to a predetermined temperature for a short time of several tens of seconds and kept at a definite temperature.

Moreover, symbol 3 is an ozone generator connected with the gas pipe 2b. Symbols 4a to 4c are vessels for storing TEOS, TMPO, and TMB solutions, which are sealed. The vessels 4a to 4c connect with the gas pipes 2c, 2e, and 2g respectively.

Symbols 6a to 6d are mass-flow controllers for controlling the flow rate of O₂ gas or N₂ gas serving as a carrier gas, 7a to 7c are heaters provided outside the vessels 4a to 4c for heating TEOS vessel 4a, TMPO vessel 4b, and TMB vessel 4c and keeping their temperature respectively.

The TMPO vessel 4b is used to form a PSG (phospho-silicate glass) film and the TMB vessel 4c is used to form a BSG (boro-silicate glass) film. To form a BPSG (boro-phospho silicate glass), the solutions in the both vessels are used.

A reaction gas feeder comprises the above components. A reaction gas supplied from the reaction gas feeder is sent to a film forming section comprising a wafer holder 21, heater 28, and gas distributor 30. Symbol 21 is a wafer holder for mounting a wafer on and secure it to a wafer mounting surface with a vacuum chuck or the like, 28 is a heater provided separately from the wafer holder 21 for indirectly heating the wafer 24 by heating the wafer holder 21, and 30 is a gas distributor provided so as to face the wafer mounting surface for discharging a reaction gas onto the surface of the wafer 24 on the wafer mounting surface.

As described above, the reaction gas feeder of the embodiment of the present invention makes it possible to closely cover with the heat pipe 1 even a portion such as a joint on which it is difficult to wind a ribbon heater due to complex shapes of the gas pipes 2a, 2c, 2e, 2g, and 2i for supplying a reaction gas to a film forming section from the reaction gas feeder because the heat pipe 1 is used to heat the gas pipes 2a, 2c, 2e, 2g, and 2i and keep the temperatures of them. Therefore, it is possible to uniformly keep the temperatures of the gas pipes 2a, 2c, 2e, 2g, and 2i at a predetermined value with a simple means and without a lot of labor.

Thereby, it is possible to prevent the reaction gas from liquefying due to drop of the temperature of the gas pipes 2a, 2c, 2e, 2g, and 2i and residue from sticking to the inner walls of the gas pipes 2a, 2c, 2e, 2g, and 2i, whereby it is possible to prevent the composition and pressure of the reaction gas from fluctuating.

### (2) Constitutions of gas distributor, wafer holder, and heater of CVD apparatus of embodiment of present invention

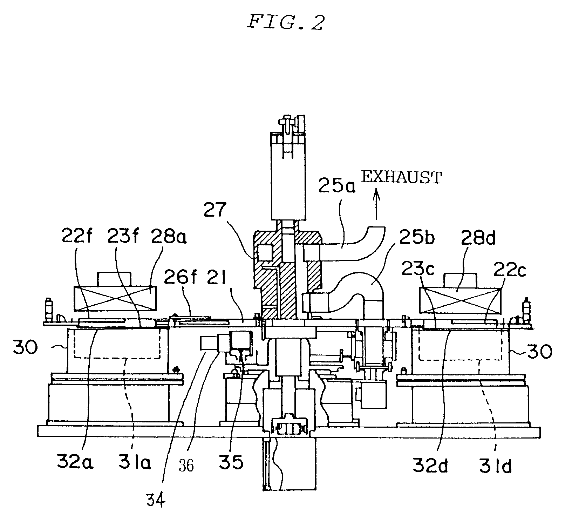

The constitutions of a gas distributor, wafer holder, and heater of the CVD apparatus of the embodiment of the present invention are described below by referring to Fig. 2 to Fig. 4.

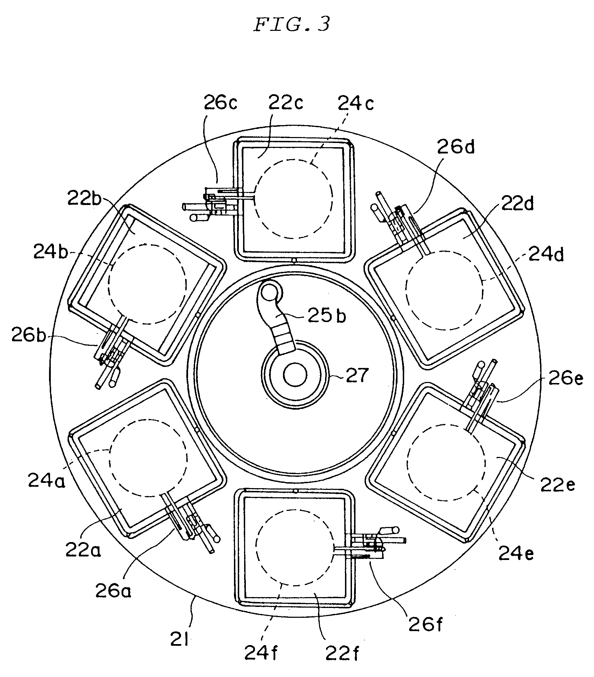

In Fig. 2 and Fig. 3, symbol 21 is a discoid wafer holder on which six detachable susceptors (wafer mounting tables) 22a to 22f are set. The susceptors 22a to 22f are made of stainless steel and have a large heat capacity so that a temperature raised by a heater hardly lowers. Wafers 24a to 24f are mounted on wafer mounting surfaces 23a to 23f of the susceptors 22a to 22f so that the depositing surfaces of the wafers 24a to 24f are turned downward. An exhaust port/gas-introduction port 25a is connected to the wafer holder 21 through a pipe 25b to fix the mounted wafers 24a to 24f with a vacuum chuck or take away a fixed wafer by blowout of N₂ gas. Moreover, the susceptors 22a to 22f are respectively provided with a not-illustrated oscillation unit which rotates around an axis vertical to each of the wafer mounting surfaces 23a to 23f or linearly moves in the radial direction.

Symbols 26a to 26f are temperature measuring means for measuring the temperatures of the wafers set to the susceptors 22a to 22f, which use thermocouples.

Symbol 27 is a rotary shaft for securing the wafer holder 21 and making the wafer holder 21 rotate in the circumferential direction around itself.

Symbols 28a to 28f are heaters (heating means) provided so as to face the moving surface of the wafer holder 21. The heaters 28a to 28f are separated from each other so as to supply electric power independently, which indirectly heat the wafers 24a to 24f by heating the susceptor 22a to 22j upon supplying energy by means of heat radiation or heat conduction from the opposite side to the wafer mounting surfaces 23a to 23f of the susceptors 22a to 22f. However, Fig. 1 shows only the heaters 28c and 28f among the heaters 28a to 28f. Each of the heaters 28a to 28f can vertically turn on each of rotary shafts parallel with gas discharge surfaces 32a to 32e so that the susceptors 22a to 22f can be detached in a formed space above them. However, the rotary shafts are not illustrated.

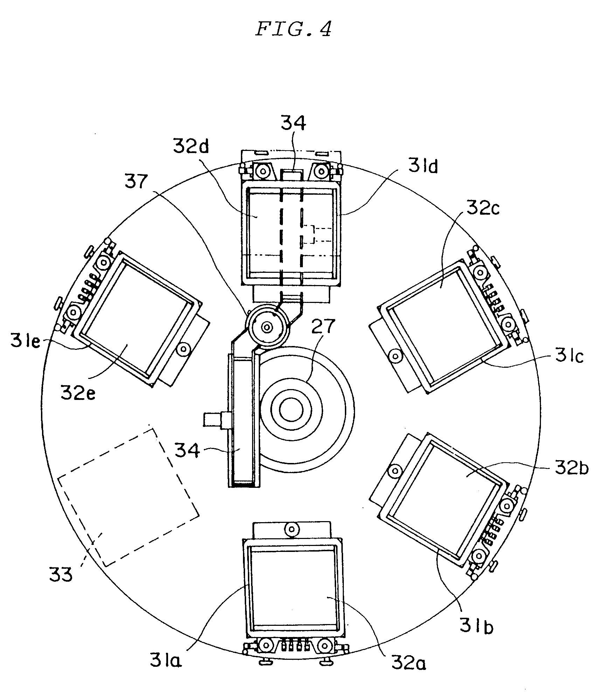

In Fig. 2 and Fig. 4, symbol 30 is a gas distributor for supplying a reaction gas sent to wafers from the reaction gas feeder. Because the gas distributor 30 supplies the reaction gas independently to each wafer on the susceptors, it has gas dischargers 31a to 31e separately from each other. The gas dischargers 31a to 31e are set at five places along the circumferential direction around the rotary shaft 27 at intervals corresponding to the positions of the susceptors 22a to 22f. Gas discharging surfaces 32a to 32e of the gas dischargers 31a to 31e are turned upward so as to face the susceptors 22a to 22f. However, a gas discharger is not set at one place which serves as a loading/unloading section 33.

Each of the gas dischargers 31a to 31e, as shown in Fig. 1, connects with the gas pipe 2i further branched from the gas pipe 2a connecting with the gas pipes 2b, 2c, 2e, and 2g through which each source gas circulates.

That is, the gas dischargers 31a and 31b connect with one reaction gas feeder shown in Fig. 1 through the gas pipe 2c branched to the source of TEOS, gas pipe 2b branched to the source of O₃ gas, gas pipe 2a connecting with the gas pipes 2c and 2b, and gas pipe 2i branched from the gas pipe 2a, in order to discharge the mixed gas of TEOS and O₃.

The gas dischargers 31c to 31e connect with the other reaction gas feeder shown in Fig. 1 through the gas pipe 2c branched to the source of TEOS, gas pipe 2b branched to the source of O₃, gas pipe 2e branched to the source of TMPO, gas pipe 2a connecting with the gas pipes 2c, 2b, and 2e, and gas pipe 2i branched from the gas pipe 2a, in order to discharge the mixed gas of TEOS, O₃, and TMPO.

Moreover, the gas pipes 2a, 2c, 2e, 2g, and 2i are covered with the heat pipe 1 shown in Fig. 1 so that they can be kept at a temperature equal to or higher than the source heating temperature.

A not-illustrated exhaust port for exhausting used or unnecessary reaction gas discharged from the gas dischargers 31a and 31b are provided at the periphery of each of the gas dischargers 31a to 31e.

Symbol 34 is a cleaner for removing reaction products or the like sticking to the gas discharging surfaces 32a to 32e. The cleaner 34 is secured to a rotary shaft 36 moving together with the wafer holder 21, which is housed in the vicinity of the rotary shaft 27 of the wafer holder 21 when it is not used and moved onto the gas discharge surfaces 32a to 32e when it is used by rotating it around the rotary shaft 36. When cleaning the gas discharge surfaces 32a to 32e, the cleaner rubs the gas discharge surfaces 32a to 32e and immediately draws in removed dust so that the dust does not scatter.

### (3) Method for forming a film

A method for forming a two-layer insulating film on a wafer by using the reaction gas feeder shown in Fig. 1 and the CVD apparatus shown in Fig. 2 is described below by referring to Fig. 1 to Fig. 4 and Fig. 5 C. In this case, as shown in Fig. 5 C, a two-layer insulating film made of a CVDSiO₂ film and a PSG film with a predetermined thickness is formed on the wafers 24a to 24f while the wafer holder 21 makes a round of the rotary shaft 27. In Fig. 5 C, symbol A represents a predetermined thickness of the CVDSiO₂ film formed on the wafers 24a to 24f and B represents a predetermined thickness of the PSG film.

First, in one reaction gas feeder and the other reaction gas feeder shown in Fig. 1, TEOS and TMPO serving as sources are heated by heaters 7a and 7b to keep the source temperatures at 65°C and the temperatures of the gas pipes 2c, 2e, 2a, and 2i at 65°C or higher.

Under the above state, the first wafer 24a is transferred to the bottom of the susceptor 22a located at the loading/unloading section from a not-illustrated cassette station by a robot.

Then, the first wafer 24a is made to contact the wafer mounting surface 23a of the susceptor 22a, gas is exhausted through the suction port 25a, and a not-illustrated solenoid valve is opened to secure the first wafer 24a to the wafer mounting surface 23a with a vacuum chuck. In this case, electric power is supplied to all the heaters 28a to 28f to heat the susceptor 22a to 22f and keep the temperatures of the wafer mounting surfaces 23a to 23f of the susceptors 22a to 22f at approx. 350°C.

After the temperature of the first wafer 24a reaches approx. 350°C, the rotary shaft 27 is rotated counterclockwise to stop the susceptor 22a at a position just above the gas discharger 31a. In this case, because the moving time is as short as approx. 0.8 sec and the susceptor 22a has a large heat capacity, the temperature of the first wafer 24a hardly lowers.

Then, the valves 5b and 5a of the reaction gas feeder are opened to send O₃ to the gas pipe 2a and the valves 5d and 5c are opened to send N₂ gas containing TEOS to the gas pipe 2a.

Thus, the mixed gas of TEOS and O₃ circulates through the gas pipes 2a and 2i as a reaction gas, and is sent to the gas distributor 30 and discharged from the gas discharger 31a.

In this case, because the gas pipes 2c, 2a, and 2i are kept at a temperature of 65°C or higher which is higher than the source heating temperature, the vapor pressure of the circulating reaction gas comes to the saturated vapor pressure or lower in the gas pipes 2c, 2a, and 2i. Therefore, the gas is not liquefied on the inner walls of the gas pipes 2c, 2a, and 2i or the composition and pressure of the reaction gas does not fluctuate.

In this case, the deposition rate of an SiO₂ film comes to approx. 2,000 Å. After approx. 1 min, an SiO₂ film with the thickness of approx. 2,000 Å which is approx. 1/2 the target film thickness is formed on the first wafer 24a. While the film is formed, the susceptor 22a is made to perform a linear reciprocative motion by a not-illustrated oscillation unit in the radial direction around the position where the susceptor 22a is held. Therefore, the reaction gas is uniformly supplied onto the first wafer 24a so that a thickness and quality of the formed SiO₂ film becomes uniform.

During the above period, the second wafer 24b is mounted on the susceptor 22b located at the loading/unloading section 33 to heat the wafer 24b up to approx. 350°C in the same way as the above.

Then, the rotary shaft 27 is rotated to stop the susceptors 22b and 22a at the positions just above the gas dischargers 31a and 31b respectively. In this case, it is possible to immediately start film forming because the temperature of the second wafer 24b already reaches approx. 350°C.

Therefore, when the mixed gas of TEOS and O₃ is charged as a reaction gas from the gas dischargers 31a and 31b and this state is left as it is for approx. 1 min, an SiO² film with a thickness of approx. 4,000 Å which is the target film thickness is formed on the first wafer 24a and an SiO₂ film with a thickness of approx. 2,000 Å which is approx. 1/2 the target film thickness is formed on the second wafer 24b.

During the above period, the third wafer 24c is mounted on the susceptor 22c located at the loading/unloading section 33 to heat the third wafer 24c up to approx. 350°C in the same way as the above.

Then, the rotary shaft 27 is rotated to stop the susceptors 22c, 22b, and 22a at the positions just above the gas dischargers 31a, 31b, and 31c respectively. In this case, it is possible to immediately start film forming because the temperature of the third wafer 24c already reaches approx. 350°C.

Therefore, the valves 5b and 5a of the other reaction gas feeder are opened to send O₃ gas to the gas pipe 2a and also the valves 5d and 5c are opened to send N₂ gas containing TEOS to the gas pipe 2a, and moreover the valves 5f and 5e are opened to send N₂ gas containing TMPO to the pipe 2a. Thus, the mixed gas of TEOS, O₃, and TMPO circulates through the gas pipes 2a and 2i as a reaction gas and is sent to the gas distributor 30 to immediately discharge the mixed gas from the gas discharger 31c as a reaction gas. Also, the mixed gas of TEOS and O₃ is discharged to the gas dischargers 31a and 31b as a reaction gas. In this case, because the gas pipes 2c, 2e, 2a, and 2i are kept at a temperature of 65°C or higher which is higher than the source heating temperature, the vapor pressure of the circulating reaction gas comes to the saturated vapor pressure or lower in the gas pipes 2c, 2e, 2a, and 2i, whereby the circulating reaction gas is not liquefied on the inner walls of the gas pipes 2c, 2e, 2a, and 2i and the composition of the reaction gas does not fluctuate.

When the above state is kept for approx. 1 min, a PSG film with a thickness of approx. 2,000 Å which is approx. 1/3 the target film thickness is formed on the first wafer 24a and an SiO₂ film with a thickness of approx. 4,000 Å which is the target film thickness is formed on the second wafer 24b, and moreover, an SiO₂ film with a thickness of approx. 2,000 Å which is approx. 1/2 the target film thickness is formed on the third wafer 24c.

Wafers are set to the susceptors 22d to 22f and sent one by one in the above way to form a two-layer insulating film made of an SiO₂ film and PSG film is formed on each wafer. When the first wafer 24a makes a round of the rotary shaft 27 and returns to the loading/unloading section 33, a two-layer insulating film made of an SiO₂ film and PSG film with the target thickness is formed on the first wafer 24a. During the above period, the wafer temperature for forming a film is very stable because it is kept almost constant.

Then, the robot is moved to the loading/unloading section 33 to close the solenoid valve corresponding to the vacuum chuck of the susceptor 22a and send N₂ gas to the vacuum chuck by opening a not-illustrated valve at the nitrogen-gas introduction port.

Then, the first wafer 24a is separated from the wafer mounting surface 23a and held by the robot. Then, the first wafer 24a is transferred to a not-illustrated cooling chamber on the cassette station. The first wafer 24a transferred to the cooling chamber is air-cooled by blowing N₂ gas on it and the cooled first wafer 24a is stored in the wafer cassette.

Thus, a two-layer film made of an SiO₂ film and PSG film with the predetermined thickness is successively formed on wafers which are accumulated in the wafer cassette.

As described above, the method for forming a two-layer film made of an SiO₂ film and PSG film using the above CVD apparatus makes it possible to prevent a reaction gas from liquefying due to drop of the temperatures of the gas pipes 2a, 2c, 2e, 2g, and 2i for supplying a reaction gas to the gas distributor 30 at the film forming section from a reaction gas feeder and prevent the residue from sticking to the inner walls of the gas pipes 2a, 2c, 2e, 2g, and 2i because the temperatures of the gas pipes 2a, 2c, 2e, 2g, and 2i are kept higher than the source temperature by the heat pipe 1 covering the gas pipes 2a, 2c, 2e, 2g, and 2i.

Therefore, it is possible to prevent the gas pipes 2a, 2c, 2e, 2g, and 2i from clogging and the composition and pressure of the reaction gas from fluctuating. Thus, it is possible to form a two-layer film made of an SiO₂ film and PSG film with a uniform quality and thickness.

Moreover, it is possible to keep a high throughput because the loading/unloading time is not explicitly added to the time actually needed for completing film forming through loading/unloading wafers while forming a film.

Furthermore, accurate production control of each wafer is realized by setting the susceptors 22a to 22f and the gas dischargers 31 to 31e separately from each other.

Furthermore, a reaction gas is uniformly supplied to wafers because each of the susceptors 22a to 22f independently performs a linear reciprocative motion on the one plane around the position where each of them is held.

Furthermore, the wafer temperature is kept almost constant because the wafer holder 21 has a large heat capacity and is able to complete movement in a short time though the heaters 28a to 28f are separate from the wafer holder 21 and the wafer holder 21 is separate from the heaters 28a to 28f while the wafer holder 21 moves.

Therefore, it is possible to form a film with a uniform thickness and quality on a wafer.

For the above semiconductor device fabrication method, two types of reaction gases are used to form a two-layer insulating film. However, as shown in Fig. 5A, it is also possible to form a single film on the wafer 24l while the wafer 24l goes round by flowing one type of a reaction gas through the gas dischargers 31a to 31e.

Moreover, as shown in Fig. 5B, it is possible to form a single film by a method similar to a batch system in which the wafers 24g to 24k are set to all the susceptors 22a to 22f and thereafter a film is simultaneously formed on the wafers 24g to 24k by using one type of a reaction gas.

## Claims

1. An apparatus for forming a film, comprising:
a reaction gas feeder for evaporating a source by heating it to supply a reaction gas;
a wafer holder (21) for mounting a wafer (24) on which a film is to be formed;
a gas distributor (30) provided separately from the wafer holder (21) to discharge a reaction gas to the wafer (24);
a gas pipe (2a) and (2i) connecting the reaction gas feeder with the gas distributor (30) and sending a reaction gas from the reaction gas feeder to the gas distributor (30); and
a heat pipe (1) covering the gas pipe (2a) and (2i).

2. An apparatus for forming a film according to Claim 1, wherein the apparatus for forming a film has a rotary shaft (27) for supporting the wafer holder (21) so that the wafer mounting surface (23a) to (23f) rotates in the circumferential direction on one plane and heating means (28a) to (28f) being separated from the wafer holder (21) and facing the moving surface on which the wafer mounting surface (23a) to (23f) of the wafer holder (21) rotates and moves.

3. An apparatus for forming a film according to Claim 2, wherein the wafer holder (21) has a plurality of wafer mounting tables (22a) to (22f) separated from each other.

4. An apparatus for forming a film according to Claim 3, wherein the heating means (28a) to (28f) has a plurality of heaters separated from each other at intervals corresponding to the wafer mounting tables (22a) to (22f).

5. An apparatus for forming a film according to Claim 3, wherein the gas distributor (30) has a plurality of gas dischargers (31a) to (31e) separated from each other and gas pipes extended from the reaction gas feeder respectively connect with the gas dischargers so that a reaction gas can independently be supplied to each gas discharger(31a) to (31e).
